# EUROPÄISCHE PATENTSCHRIFT

(11) **EP 0 772 959 B1**
(45) Veröffentlichungstag und Bekanntmachung des Hinweises auf die Patenterteilung: **18.03.1998**
(21) Anmeldenummer: 95924862.6
(22) Anmeldetag: 14.07.1995
(51) Int. Cl.: H05K 5/00, H05K 5/06, B60R 16/02

(54) **WASSERDICHTES GEHÄUSE MIT EINER STECKVERBINDUNG ZUM SCHUTZ VON ELEKTRONIKSCHALTKREISEN**
WATERPROOF HOUSING WITH A PLUG CONNECTOR FOR PROTECTING ELECTRONIC CIRCUITS
BOITIER ETANCHE A L'EAU POURVU D'UN CONNECTEUR A FICHES SERVANT A PROTEGER LES CIRCUITS ELECTRONIQUES

(30) Priorität: 28.07.1994 DE 4426812
(43) Veröffentlichungstag der Anmeldung: 14.05.1997
(73) Patentinhaber: SIEMENS AKTIENGESELLSCHAFT, 80333 München (DE)
(72) Erfinder: BAUER, Peter, D-93047 Regensburg (DE); DIRMEYER, Josef, D-92439 Bodenwöhr (DE); PLANKL, Christian, D-93055 Burgweinting (DE); VAN HOUDENHOVE, Rony, B-8755 Ruiselede (BE)
(86) Internationale Anmeldenummer: DE9500928
(87) Internationale Veröffentlichungsnummer: WO9603852

(56) Entgegenhaltungen:
- DE-A- 3 728 456
- DE-A- 4 329 980
- DE-C- 4 240 727
- DE-U- 8 700 213
- PATENT ABSTRACTS OF JAPAN vol. 18 no. 230 (E-1542) ,26.April 1994 & JP,A,06 021666 (ZENITANI HIDEKI) 28.Januar 1994,

## Beschreibung

Die Erfindung betrifft ein wasserdichtes Gehäuse mit einer Steckverbindung zum Schutz von Elektronikschaltkreisen gemäß Oberbegriff des Patentanspruchs 1.

Elektronikschaltkreise im Inneren eines solchen Gehäuses werden über nach außen geführte Kontaktstifte mit weiteren Schaltkreisen, z.B. einer Stromversorgung oder einem Signalschaltkreis verbunden. Die Kontaktstifte werden über ein am Gehäuse angeordnetes Steckerteil nach außen geführt. Durch Einstecken eines Gegensteckers in das Steckerteil wird eine elektrisch leitende Verbindung zwischen dem Elektronikschaltkreis und den weiteren Schaltkreisen hergestellt. Die Elektronikschaltkreise müssen bei ihrem Einsatz - beispielsweise in Kraftfahrzeugen - durch das Gehäuse vor äußeren Einflüssen, insbesondere vor einem Eindringen von Wasser, geschützt werden. Dabei sind das Steckerteil sowie die Nahtstelle zwischen einem Oberteil und einem Unterteil des Gehäuses Schwachpunkte des Gehäuses.

Ein bekanntes Gehäuse mit einer Steckverbindung (DE 37 28 456 A1) weist zwei Gehäuseteile - ein Oberteil und ein Unterteil - sowie einen Elektronikschaltkreis im Inneren des Gehäuses auf. Die beiden Gehäuseteile sind miteinander verschraubt. An der Fügestelle zwischen Oberteil und Unterteil ist eine Dichtung in Form eines Dichtrings angeordnet, die in eine Vertiefung des Unterteils eingelegt ist. Eine Öffnung des Oberteils weist eine mit dem Oberteil verschraubtes Steckerteil mit Kontaktstiften auf, wobei ein weiterer Dichtring zwischen Steckerteil und Oberteil angeordnet ist.

Aufgabe der vorliegenden Erfindung ist es, ein Elektronikschaltkreise schützendes Gehäuse mit einer Steckverbindung anzugeben, das insbesondere im Bereich des Steckerteils eine zuverlässige Abdichtung gegen Umwelteinflüsse aufweist. Das Gehäuse soll außerdem möglichst wenig Einzelteile aufweisen und kostengünstig zu fertigen sein.

Die Aufgabe wird durch die Merkmale des Anspruchs 1 gelöst.

Ober- und Unterteil des Gehäuses werden aus hartem Kunststoff hergestellt. Eine gespritzte Dichtung aus weichem Kunststoff zwischen dem Ober- und dem Unterteil des Gehäuses ersetzt ein separates Dichtungselement. Das Steckerteil weist ein Innenteil aus einem harten Kunststoff und einen das Innenteil umfassenenden Dichtkragen aus weichem Kunststoff auf. Das Innenteil des Steckerteils ist einstückig mit dem Ober- oder dem Unterteil des Gehäuses ausgebildet. Kontaktstifte, die eine elktrisch leitende Verbindung mit dem Elektronikschaltkreis im Inneren des Gehäuses herstellen, sind im Innenteil des Steckerteils eingebettet. Damit ist das Steckerteil gegen das Gehäuse ohne ein zusätzliches Dichtungselement abgedichtet. Ein aus hartem Kunststoff hergestellter Gegenstecker liegt im in das Steckerteil eingeführten Zustand dicht am Dichtkragen des Steckerteils an, sodaß auch die Steckverbindung selbst zuverlässig gegen das Eindringen von Wasser abgedichtet ist. Die Gehäusebestandteile aus hartem und weichem Kunststoff werden in derselben Spritzform hergestellt.

Vorzugsweise erweitert sich der Dichtkragen nach außen, beispielsweise kegelförmig, sodaß ein anzuschließender Gegenstecker leicht eingeführt werden kann. Wird der Gegenstecker nicht vollständig in das Steckerteil eingeschoben, fällt er aufgrund der Kegelform des Dichtkragens aus dem Steckerteil heraus. Damit kann überprüft werden, ob der Gegenstecker vollständig eingeschoben wurde. Zusätzlich können Dichtkragen und die Außenform des Gegensteckers derart gestaltet sein, daß eine falsche Polung der Kontaktstifte nicht möglich ist.

Wird das erfindungsgemäße Gehäuse beispielsweise in ein Kraftfahrzeug eingebaut, kann man das Abweisen von Wasser durch sogenannte Tropfnasen an der Außenwand des Gehäuses unterstützen. Das Wasser tropft an der Tropfnase ab und rinnt nicht bis zur Fügestelle zwischen den Gehäuseteilen. Damit die Tropfnasen unabhängig von der Einbaurichtung des Gehäuses ihre Wirkung entfalten, werden sie drehbar ausgestaltet.

Die Erfindung und ihre Weiterbildungen werden anhand der Zeichnung erläutert. Es zeigen:
- Fig. 1:: eine perspektivische Ansicht eines erfindungsgemäßen Gehäuses,
- Fig. 2:: eine perspektivische Ansicht des Gehäuseoberteils
- Fig. 3:: einen Längsschnitt durch das Gehäuse von Fig. 1 entlang Linie I-I und
- Fig. 4:: einen Längsschnitt durch einen Gegenstecker für das Steckerteil des Gehäuses.

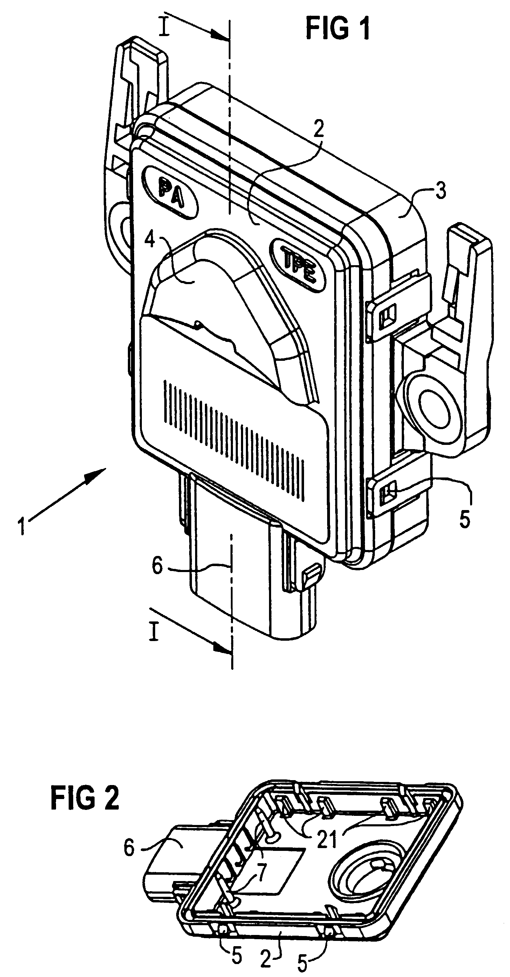

Figur 1 zeigt ein erfindungsgemäßes Gehäuse 1 mit einem Oberteil 2 und einem Unterteil 3. Das Oberteil 2 weist eine Tropfnase 4 auf. Die Tropfnase 4 ist drehbar, sodaß sie unabhängig von der Einbaurichtung des Gehäuses 1 beispielsweise in eine Fahrzeug Tropfen abweist. Oberteil 2 und Unterteil 3 des Gehäuses 1 sind über Schnappverschlüsse 5 miteinander verbunden. Das Oberteil 2 weist ein Steckerteil 6 zur Aufnahme eines Gegensteckers auf.

Figur 2 zeigt eine perspektivische Ansicht des Unterteils 3 des Gehäuses 1 nach Figur 1. Im Inneren des Unterteils 3 sind Plattenlager 21 und Zapfen 7 angeordnet, zwischen denen eine Leiterplatte mit elektronischen Bauelementen angeordnet werden kann. Desweiteren zeigt Figur 2 das am Unterteil 3 des Gehäuses angeordnete Steckerteil 6.

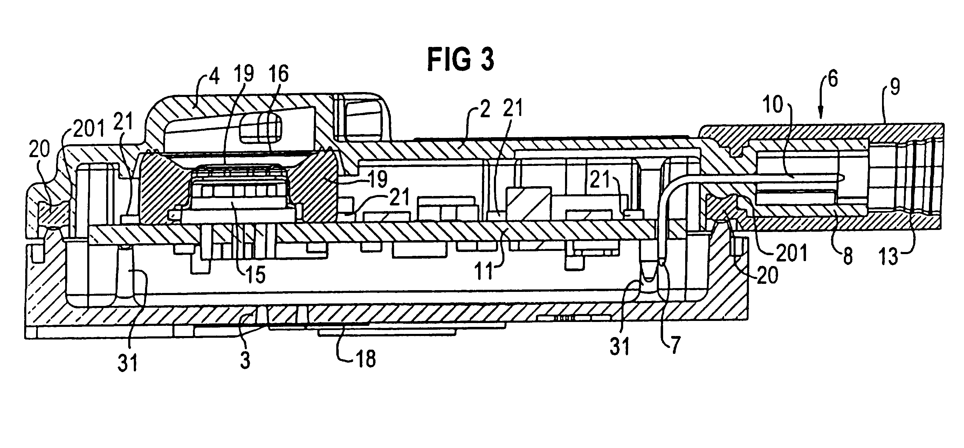

Fig. 3 zeigt einen Längsschnitt durch ein geschlossenes Gehäuse 1 mit dem Oberteil 2 und dem Unterteil 3. Ein Innenteil 8 eines Steckerteils 6 ist einstückig mit dem Oberteil 2 des Gehäuses 1 ausgebildet. Das Innenteil 8 ist aus dem gleichen harten Kunststoff wie das Oberteil 2 und das Unterteil 3 hergestellt. Kontaktstifte 10, die zur Leiterplatte 11 führen, sind im harten Innenteil 8 des Steckerteils 6 fest eingebettet.

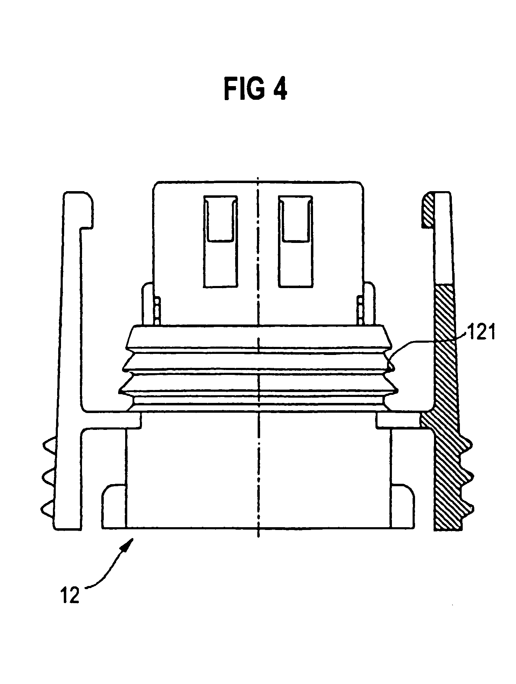

Ein Dichtkragen 9 aus einem weicheren Kunststoff umschließt das Innenteil 8. Der Querschnitt des Dichtkragens 9 erweitert sich kegelförmig nach außen in Form von stufig angebrachten Dichtlippen. Ein Führungsteil 12 (Figur 4) - für Gegenstecker ist aus hartem Kunststoff gefertigt und weist an seinem Umfang Dichtlippen 121 auf, die in die entsprechenden Formungen des Dichtkragens 9 eingreifen und eine gute Abdichtung gewährleisten.

In einer Nut 201 (Figur 3), die die Fügestelle zwischen Oberteil 2 und Unterteil 3 des Gehäuses bildet, ist eine Dichtung 20 aus weicherem Kunststoff angeformt.

## Patentansprüche

1. Wasserdichtes Gehäuse mit einer Steckverbindung zum Schutz von Elektronikschaltkreisen, mit einem Oberteil (2), einem Unterteil (3) und mit einer zwischen dem Oberteil (2) und dem Unterteil (3) angeordneten Dichtung (20),
**dadurch gekennzeichnet,**
- daß die gespritzte Dichtung (20) aus weichem Kunststoff, und das Oberteil (2) sowie das Unterteil (3) aus hartem Kunststoff hergestellt sind,
- daß das Gehäuse ein Steckerteil (6) aufweist, dessen aus hartem Kunststoff hergestelltes Innenteil (8) Kontaktstifte (10) enthält und einstückig mit dem Oberteil (2) oder dem Unterteil (3) ausgebildet ist, und
- daß das Steckerteil (6) einen sein Innenteil (8) umfassenden Dichtkragen (9) aus weichem Kunststoff (8) aufweist.

2. Gehäuse nach Anspruch 1
**dadurch gekennzeichnet,**
daß der Dichtkragen (9) des Steckerteils (6) sich kegelig nach außen erweitert.

3. Gehäuse nach Anspruch 1
**dadurch gekennzeichnet,**
daß der Dichtkragen (9) mehrere Dichtlippen aufweist.

4. Gehäuse nach Anspruch 1
**dadurch gekennzeichnet,**
daß an der Außenseite des Gehäuses eine Tropfnase (4) angeordnet ist.

5. Gehäuse nach Anspruch 1
**dadurch gekennzeichnet,**
daß an einem Teil des Gehäuses schräge biegsame Zapfen (7) angebracht sind, die eine im Inneren des Gehäuses angeordnete Leiterplatte (11) halten.

6. Gehäuse nach Anspruch 1
**dadurch gekennzeichnet,**
daß ein Führungsteil (12) für einen Gegenstecker auf seinem Außenumfang Dichtlippen (121) aus hartem Kunststoff aufweist.

7. Gehäuse nach Anspruch 1
**dadurch gekennzeichnet,** daß die Dichtung (20) und der Dichtkragen (9) des Steckerteils (6) einstückig ausgebildet sind.

## Claims

1. Waterproof housing with a plug-and-socket connection for protecting electronic circuits, having an upper part (2) and a lower part (3), and having a seal (20) arranged between the upper part (2) and the lower part (3), characterized
- in that the moulded seal (20) is produced from soft plastic, and the upper part (2) and the lower part (3) are produced from hard plastic,
- in that the housing has a plug part (6) whose inner part (8), produced from hard plastic, contains contact pins (10) and is constructed in one piece with the upper part (2) or the lower part (3), and
- in that the plug part (6) has a sealing collar (9) which surrounds its inner part (8) and is made from soft plastic.

2. Housing according to Claim 1, characterized in that the sealing collar (9) of the plug part (6) widens outwards conically.

3. Housing according to Claim 1, characterized in that the sealing collar (9) has a plurality of sealing lips.

4. Housing according to Claim 1, characterized in that a drip nose (4) is arranged on the outside of the housing.

5. Housing according to Claim 1, characterized in that inclined flexible pins (7) which hold a printed circuit board (11) arranged in the interior of the housing are fitted on a part of the housing.

6. Housing according to Claim 1, characterized in that a guide part (12) for a mating connector has on its outer circumference sealing lips (121) made from hard plastic.

7. Housing according to Claim 1, characterized in that the seal (20) and the sealing collar (9) of the plug part (6) are constructed in one piece.

## Revendications

1. Boîtier étanche à l'eau comportant un connecteur mâle-femelle pour la protection de circuits électroniques, une partie supérieure (2), une partie inférieure (3) et un joint d'étanchéité (20) placé entre la partie supérieure (2) et la partie inférieure (3),
caractérisé en ce que,
- le joint d'étanchéité (20) injecté est réalisé en matière synthétique molle et la partie supérieure (2) ainsi que la partie supérieure (3) sont réalisées en matière synthétique dure,
- le boîtier comporte une prise (6), dont la partie intérieure (8) fabriquée en matière synthétique dure contient des broches de contact (10) et forme une pièce unique avec la partie supérieure (2) ou la partie inférieure (3), et
- la prise (6) comporte un collet d'étanchéité (9) en matière synthétique molle (8) entourant sa partie intérieure (8).

2. Boîtier selon la revendication 1
caractérisé en ce que,
le collet d'étanchéité (9) de la prise (6) s'élargit vers l'extérieur en forme de cône.

3. Boîtier selon la revendication 1
caractérisé en ce que,
le collet d'étanchéité (9) comporte plusieurs lèvres d'étanchéité.

4. Boîtier selon la revendication 1
caractérisé en ce que,
un rejetteau (4) est placé sur l'extérieur du boîtier.

5. Boîtier selon la revendication 1 caractérisé en ce que,
dans l'une des parties du boîtier, sont prévus des tenons (7) flexibles, obliques, qui tiennent une carte de circuits imprimés (11) disposée à l'intérieur du boîtier.

6. Boîtier selon la revendication 1 caractérisé en ce que,
une pièce de guidage (12), pour une fiche complémentaire comporte sur sa périphérie extérieure, des lèvres d'étanchéité (121) en matière synthétique dure.

7. Boîtier selon la revendication 1 caractérisé en ce que,
le joint d'étanchéité (20) et le collet d'étanchéité (9) de la prise (6) sont réalisées en une seule pièce.
